(19) **Europäisches Patentamt European Patent Office Office européen des brevets**

(11) **EP 4 750 228 A1**

(12) **EUROPEAN PATENT APPLICATION**

(43) Date of publication:
**27.05.2026 Bulletin 2026/22**

(21) Application number: **25151663.9**

(22) Date of filing: **14.01.2025**

(51) International Patent Classification (IPC):
**H05K 1/03** *(2006.01)* **H05K 1/16** *(2006.01)*
**H05K 3/10** *(2006.01)*

(52) Cooperative Patent Classification (CPC):
**H05K 1/165; D03D 1/0088; H05K 1/038;**
**H05K 3/105;** H05K 2201/0323; H05K 2201/10098;
H05K 2203/107; H05K 2203/1136

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **20.11.2024 GB 202417029**

(71) Applicant: **Digital Clothing Limited Tsim Sha Tsui (HK)**

(72) Inventors:
• **Li, Yi**
  **999077 Yau Ma Tei (HK)**
• **Xu, Lulu**
  **999077 Yau Ma Tei (HK)**

(74) Representative: **Chung, Hoi Kan**
  **Mandarin IP Limited**
  **7 Cherry Trees**
  **Great Shelford**
  **Cambridge CB22 5XA (GB)**

(54) **A MANUFACTURING METHOD OF NEAR-FIELD WIRELESS COMMUNICATION ANTENNAS BY USING TEXTILE MATERIALS**

(57) A manufacturing method of Near-Field wireless communication antennas by using textile materials, comprising an NFC antenna. The NFC antenna is made from LIG yarn that is laser-induced, with the LIG yarn embroidered into the fabric according to designed geometric shapes and tension. The advantages of this NFC antenna invention lie in its ability to be integrated into clothing, wearable devices, and home textiles, as well as industrial textiles, allowing for direct wireless communication with networks and smartphones.

Fig. 1a

Fig. 1b

Fig. 1c

EP 4 750 228 A1

## Description

### FIELD OF THE INVENTION

The present invention relates to a near-field communication system, specifically to a manufacturing method for near-field communication (NFC) wireless communication antennas by textile materials, and it falls in the field of NFC devices.

### BACKGROUND

Traditional research on flexible electronic devices primarily focuses on printed electronics. The printed electronic technology involves circuit transferring, inkjet printing, or soft-etching circuit onto a conductive or non-conductive flexible substrate. However, these devices often use thin films as substrates, which do not have the unique breathability and moisture permeability characteristics of fabrics. Additionally, due to the porous structure of textiles, it is challenging for such electronic devices to integrate with textile materials.

The textile NFC technology primarily involves directly knitting conductive fibers into electronic devices or connected lines by knitting machines, weaving machines, or embroidery machines, which preserves the inherent properties of the fiber such as flexibility, stretchability, breathability, and moisture permeability. However, different to the traditional electronic device design method, the design of textile material must consider the characteristics and the unique aspects of garment wear, such as: 1) the resolution of woven geometric patterns is low, that is why the geometric shapes of devices cannot incorporate fine structures; 2) the resistivity of woven yarns is significantly higher than the metals, it is necessary to optimize the geometries to minimize losses of device; 3) the electromagnetic properties of the device are insensitive to shape changes while the devices will inevitably suffer deformation integrated into clothing; 4) furthermore, the effects of parasitic capacitance and parasitic inductance in textile yarns cannot be ignored. So, the traditional methods of traditional circuit design for estimating inductance and equivalent circuit models will not apply to these applications. These challenges are unique to textile NFC technology.

However, during the manufacturing process, the conductive fibers will suffer significant tension, which may damage the conductive coating on the fiber surface, thereby affect the electrical properties of the antenna. Currently, the research on electronic devices based on textile processes is still in the testing and trial stage of individual devices, and there has been no research on textile NFC technology.

### SUMMARY OF THE INVENTION

To find solution to the above issues, the present invention designs a manufacturing method for near-field wireless communication antennas by textile materials, which can be integrated into clothing, wearable devices, home textiles, and industrial textiles to engage direct networks connection and wireless communication of smartphones.

The technical solution of the present invention is as follows.

A manufacturing method of Near-Field wireless communication antennas by using textile materials, embroidering LIG yarn into a fabric according to the designed geometric shape, and is fabricated with tension and attached to the fabric to form an NFC antenna structure with specific steps as follows:

S1. making LIG material into yarn.
S2. embroidering the LIG yarn onto the fabric according to the designed NFC antenna pattern. The LIG yarn integrates into the fabric with specific stitch geometries and tension, and ensures good stretch elasticity, comfort performance, and electrical performance. The synchronous deformation of the coil and fabric is realized by the serpentine zig-zag stitch.
S3. applying laser induction on the NFC antenna to convert the LIG yarn into graphene with conductivity.
S4. connecting the NFC antenna to the near-field communication circuit.

The fabric comprises dielectric textiles having woven, non-woven, or knitted structures, and serve as the substrate for the NFC antenna. The selected fabric has flexibility, stretchability, breathability, moisture permeability, and washability, thereby meeting the requirements for comfort, mechanical performance, and durability.

The LIG material is selected from polyimide, polysulfone, polyether sulfone, polyphenylsulfone, or carbon-based materials containing cyclic carbon structures in crystals. The carbon-based materials can be cellulose, wood, paper, food products, etc.

The laser wavelength ranged between 9.3 $\mu$m to 10.6 $\mu$m, the laser energy ranging from 50 W to 75 W, a duty cycle ranged between 4% to 10%, a frequency of 6 kHz, and a pulse count ranged between 30 to 1000 PPI. Further, the laser energy is most preferred of 60 W and a pulse count of 400 PPI.

The laser spot diameter ranges ranged between 60 $\mu$m to 90 $\mu$m, with a most referred diameter of 70 $\mu$m.

The energy density of the laser ranged between 5 to 200 mJ/cm$^2$.

The laser emission device adopts a pulse length ranged between 8 to 12 ps, a wavelength ranged between 9 to 11 $\mu$m, and a repetition rate ranged between 490 kHz to 19.9 MHz.

The NFC antenna can have various shapes, including rectangular loops, circular loops, or polygonal loops.

The dielectric fabric adopts antenna coils and chips embroidered with conductive LIG yarn to directly achieve antenna impedance matching, that is equivalent inductance; when conjugate matched, the NFC antenna and chip is arranged to operate at 13.56 MHz without any tuning circuit.

The NFC antenna has good breathability and moisture permeability.

The NFC antenna has excellent resistance to tensile deformation, bending deformation, and twisting deformation.

The NFC antenna is placed on the dielectric fabric substrate, and the antenna coil embroidered by LIG yarn is directly connected to the chip.

The fabric is made of natural or synthetic fibers.

The near-field communication wireless communication system by textile materials of the present invention can be applied to textiles, clothing or accessories. These clothes can be worn inconspicuously and can communicate with clouds, networks and electronic platforms, such as smartphones, tablets, smartwatches, etc., to realize wireless contact. It can be applied on various fabrics in home control, vehicle seat cushions, navigation, personal identification, entertainment, etc., which can be embroiled in textiles.

The NFC antenna can be flexibly embroidered into textiles, such as clothing, accessories, and home or automotive textiles, to enable data transmission to electronic platforms via wireless communication.

The dielectric fabric can be designed according to computational models, and use conductive yarn to directly achieve matching with the antenna coil and chip, ensuring maximum radiation efficiency without the need for additional electronic devices, thereby reducing energy loss.

The NFC antenna can be integrated into electronic platforms, including smartphones, reading devices, smartwatches, smart bands, computers, and POS terminals.

The NFC antenna adopts a loop structure. The conductive yarns with normal sewing which are with high breaking strength or with specific breaking characteristics in cross direction, are to be embroidered on the fabric according to the pattern untwisted.

The LIG yarn can be embroidered with standard needle techniques. For example: inner knotting such as 101 level chain lock, inner knotting such as 401 level double chain lock, and intertwist such as 301 zigzag. But yarns with high friction, easily breakable and untwisted cannot withstand high tension. Their filaments break easily under high stresses and external force speeds, so they must be fixed to the fabric with the help of other commonly used yarns to keep stable, and applied serpentine zig-zag stitch design, that is, conductive yarns are embedded in the elastic yarns and upper yarns, so that they deform synchronously with the fabric when stretched.

The fabric may be made of natural fibers such as cotton fabric, silk fabric, linen fabric, wool fabric and leather fabric or artificial fibers such as acetate fabric, chiffon fabric, acrylic fabric, organza fabric, nylon fabric. The fabric can be polyester fabric, etc. By adjusting the speed of the embroidery machine, the tension and shape of the stitches, high electrical and mechanical properties are ensured.

The distance between said NFC antenna and the electronic platform, that is, the electronic device, is around 0-20 cm.

The beneficial effects of the present invention are: a wearable NFC antenna is manufactured from textiles through embroidery, and data can be obtained and transmitted through physical contact with the textiles.

The present invention is further described below in conjunction with the accompanying drawings and examples.

## BRIEF DESCRIPTION OF THE DRAWINGS

Fig. 1 is a diagram of NFC tags with different shapes according to an embodiment of the present invention (Fig. 1a - rectangle, Fig. 1b - circle, Fig. 1c - polygon);

Fig. 2 is a structural diagram of an NFC tag embroidered on fabric, textiles or clothes according to an embodiment of the present invention;

Fig. 3 is a stitch geometry diagram of NFC according to the embodiment of the present invention (Fig. 3a - W-head embroidery suture, Fig. 3b zigzag suture, Fig. 3c 301 level flat suture, in the figure: zig-zag-snake suture, Class 107 chains-titch-107 chain stitch, Needle thread-needle thread, bobbin thread-bottom thread, Class301 lockstitch-301 level flat stitch);

Fig. 4 is an equivalent circuit diagram of an NFC tag according to an embodiment of the present invention (in the figure:

Ls-ant, Cs-ant and Rs-ant represent its inductance, parasitic capacitance and resistance respectively);

Fig. 5 is an NFC matching circuit diagram of an embodiment of the present invention (in the figure: Rs, Cs and Cp respectively represent the series/parallel resistance, series/parallel capacitance and parallel capacitance of the matching circuit);

Fig. 6 is a diagram of an NFC antenna matching an NFC chip according to an embodiment of the present invention (in the figure: diode chip - NFC chip, Matching circuit - matching circuit, NFC antenna - NFC antenna).

Fig.7 is the workflow of producing a conductive NFC antenna through laser-induced LIG yarn in the present invention.

## DESCRIPTION OF THE EMBODIMENTS

Preferred embodiments of the present invention are described below. It should be understood that the preferred embodiments described here are only used to illustrate and explain the present invention, and are not intended to limit the present invention.

Embodiment 1

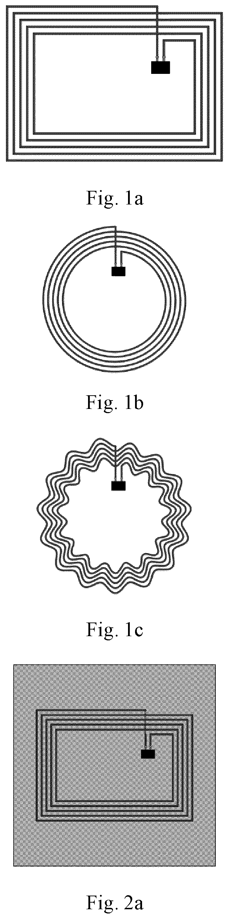

A near-field wireless communication system based on textile materials, includes an NFC antenna, which can have various shapes as shown in Fig. 1, such as a rectangular (Fig. 1a), circular (Fig. 1b), and polygonal (Fig. 1c). The shape of the NFC coil depends on the position, size, and strength in specific wearing or display areas. For example, the polygonal shape offers high stretchability and performs well under significant deformation.

By an electronic embroidery machine, the NFC antenna is embroidered onto the fabric with conductive LIG yarn to form coil 1, chip, and matching circuit 2.

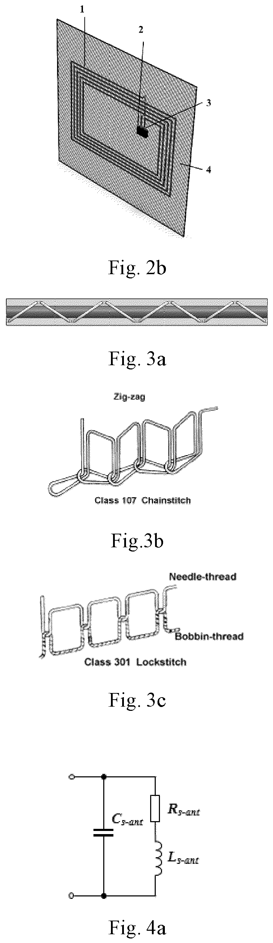

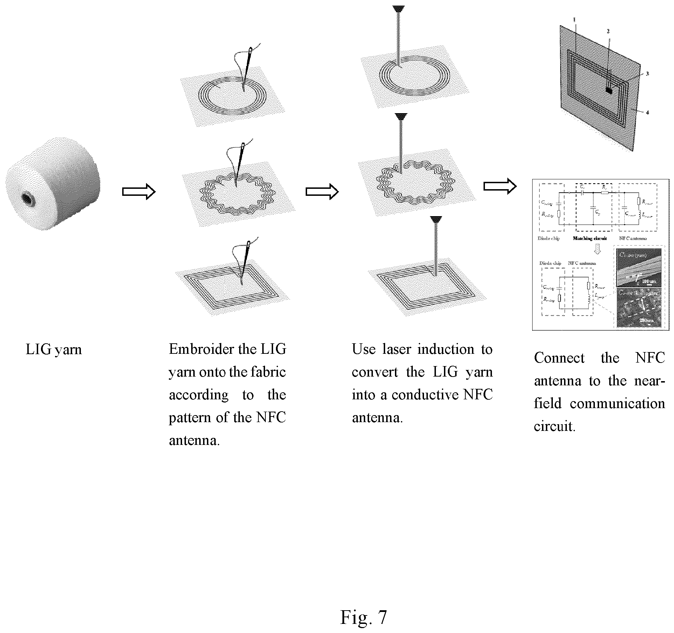

As shown in Fig. 2, the NFC antenna is embroidered or sewn onto the fabric, textile, or clothing using automated machines. Since LIG yarn is not conductive itself, the embroidered or sewn NFC antenna does not function properly until laser induction is applied along the position of the LIG yarn, converting it into graphene and forming a conductive element, as shown in Fig. 7.

To induce the LIG yarn into graphene with a laser, specific laser parameters must be applied, including laser frequency and energy density. The inventors have done the research and got suitable laser induction parameters as follows: laser frequency of 3372.8 kHz, energy density of 15.8-25.2 mJ/cm$^2$, pulse length of 10 ps, a wavelength of 355 nm, and a pulse repetition rate ranging from 490 kHz to 19.9 MHz

The NFC antenna comprises a coil 1, a chip and a matching circuit 2 made of the above-mentioned yarn formed by laser induction. The chip and matching circuit are soldered via additional conductive yarn 3. The fabric 4 used as the substrate material of the NFC antenna is made of natural fibers (such as woven cotton fabrics, silk fabrics, linen fabrics, wool fabrics and leather fabrics), man-made fibers (such as acetate fabrics, chiffon fabrics, acrylic fabrics, Organza fabric, latex fabric, nylon fabric, polyester fabric, etc.), made of the non-woven or knitted structure.

The LIG yarn is designed according to the conductivity and inductance requirements of the NFC coil. Fine and smooth LIG yarn can be embroidered using a standard embroidery machine. The geometric shapes of zigzag and Class 301 stitching are illustrated in Fig. 3, including 3a (W-head embroidery stitch), 3b (zigzag stitch), and 3c (Class 301 straight stitch). High-friction and easily breakable yarns (e.g., stainless steel yarn) can be placed on the fabric and moved smoothly by positioning them near the needle.

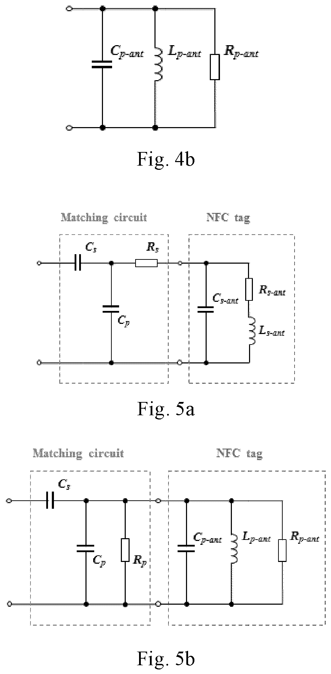

The NFC antenna is essentially a conductive coil with a specific number of turns. Therefore, its equivalent circuit can be represented by an inductor, a parasitic capacitor, and a resistor. Fig. 4 illustrates the equivalent circuit of the NFC tag with series and parallel configurations. Ls/p-ant, Cs/p-ant and Rs/p-ant represent the inductance, parasitic capacitance, and resistance, respectively. It should be noted that the magnitude of the parasitic capacitance Cs-ant is only 10pF. Therefore, the electrical characteristics of an NFC tag are affected by its inductance and resistance.

In order to maximize antenna efficiency, a matching circuit is usually applied to ensure that the equivalent impedance of the NFC tag with the matching circuit is conjugated to match the NFC reader. Fig. 5 shows typical series matching circuits and parallel matching circuits for NFC tags. Rs/p, Cs/p and Cp represent the series/parallel resistance, series/parallel capacitance and parallel capacitance of the matching circuit respectively.

The parasitic capacitance formed along the yarn can be modelled as a capacitor, which is connected in parallel with the series inductor and resistor, as shown in Fig. 5. Generally, a matching circuit is inserted between the NFC chip and the coil antenna to adjust the operating frequency to 13.56 MHz. If the impedances of the antenna and the NFC chip are conjugately matched, no matching circuit is needed, allowing for maximum energy transfer between the chip and the antenna.

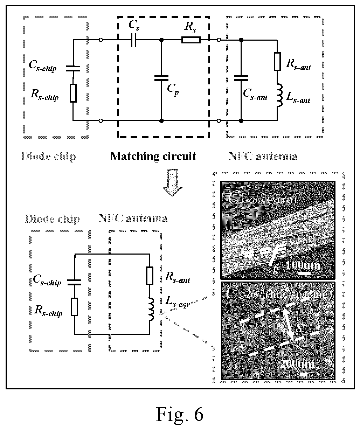

For the NFC coil antenna shown in Fig. 6, L_(s-ant) t is the intrinsic inductance, which can be derived according to Wheeler's formula, as follows:

$$L_{s-ant} = \frac{L_{wheeler}}{\rho_1} \quad (1)$$

$\rho1$ is the correction inductance coefficient of the embroidered coil. The parasitic capacitance and intrinsic resistance are represented respectively. The impedance of the antenna is denoted as (2).

$$Z_{ant} = \frac{R_{s-ant} + j\omega L_{s-ant}}{1 - \omega^2 L_{s-ant} C_{s-ant} + j\omega R_{s-ant} C_{s-ant}} (2)$$

Where $\omega$ is the angular frequency, approximately 10 MHz. In some NFC applications, $R_{(s-ant)}$, $L_{(s-ant)}$ and $C_{(s-ant)}$ are of $1\Omega$, $1\mu H$ and $1pF$ respectively. Using the magnitude of the variable in the formula $|j\omega R_{(s\_ant)}C_{(s-ant)}| \ll 1|$, the reactant part of (2) can be simplified to (3).

$$I_m(Z_{tag}) \approx \frac{\omega L_{s-ant}}{1 - \omega^2 L_{s-ant} C_{s-ant}} (3)$$

In order to achieve conjugate matching between the chip and the antenna, we can simplify the reactance part of the impedance Z_ant into an inductor, that is, the equivalent inductance $L_{(s-eqv)}$, which has integrated parasitic capacitance, capacitance value. $L_{(s-eqv)}$ can be expressed as (4), and the conjugate matching connection with the chip is shown in Fig. 5.

$$L_{s-eqv} = \frac{L_{s-ant}}{1 - \omega^2 L_{s-ant} C_{s-ant}} (4)$$

The parasitic capacitance $C_{(s-ant)}$ is related to the gap formation along the suture. Quantitatively, $C_{(s-ant)}$ is directly proportional to the total length of the air gap along the line $l\_g$ and the thickness of the line, and inversely proportional to the tiny gap g. The parasitic capacitance can be expressed as (5).

$$C_{s-ant} = \frac{l_g t}{g} \varepsilon_{yarn} (5)$$

$\varepsilon$_yarn can be viewed as the absolute dielectric constant of air and textile matrix. g and t are values affected by yarn properties. However, the precise values of g and t cannot be quantified due to the fine gap distribution in the twisted fibers.

The length of the air gap along the suture $l\_g$ is a geometric factor that is closely related to the length of the conductor and can be calculated based on the geometry of the coil, as shown in (6) and (7) for circular and square coils respectively. where n is the number of turns of the coil. a=0.5(r_i+r_o), b=r_o-r_i, r_o and r_i are the outer radius and inner radius of the coil respectively. r_i=r_o-n(s+w)-w.

$$l_{g-circle} = 2\pi an (6)$$

$$l_{g-square} = 8an \, (7)$$

The reciprocal of $L_{(s-eqv)}$ can be expressed by (8).

$$\frac{1}{L_{s-eqv}} = \frac{1 - \omega^2 L_{s-ant} C_{s-ant}}{L_{s-ant}} = \frac{1}{L_{s-ant}} - \omega^2 C_{s-ant} \quad (8)$$

By substituting equations (6) or (7) into equation (5), and then substituting equations (5) and (1) into equation (8), the equivalent coil inductance can be expressed as equation (9).

$$L_{s-eqv} = 1/\left(\frac{\rho_1}{L_{wheeler}} - \rho_2\omega^2 na\right)(9)$$

Since the variables ε_yarn, g and t are all structure-related variables, they are difficult to quantify with definite values. For simplicity, these variables are combined into one coefficient ρ_2.

$$\rho_{2-circle} = 2\pi t\varepsilon_{yarn}/g (10)$$

$$\rho_{2-square} = 8t\varepsilon_{yarn}/g (11)$$

The operating resonant frequency is determined by (12), and if the coil parasitic capacitance C_(s-ant) is ignored, its accuracy will be affected. Table 3 lists the impedance of the NFC chip and its conjugate matched antenna impedance, that is, the equivalent inductance.

$$f = \frac{1}{2\pi\sqrt{L_{s-eqv}C_{s-chip}}}(12)$$

When the NFC coil formed by LIG yarn achieves conjugate matching, the NFC antenna and chip can operate at the desired frequency of 13.56 MHz without the need for any tuning circuits.

The product of the present invention is an application of NFC based on textiles. It can be embroidered on textile systems including clothing, accessories such as hats and bags, as well as home textiles, car seat cushions, etc. The embroidered antenna will reduce the price of NFC during the manufacturing process, thus promoting the application of NFC in the Internet of Things. By integrating NFC directly into textiles as a necessity rather than an accessory, it can be used for monitoring, health care, home control, entertainment and other purposes that will have a huge impact on daily life.

## Claims

1. A manufacturing method of Near-Field wireless communication antennas by using textile materials, embroidering LIG yarn into a fabric according to the designed geometric shape, and is fabricated with tension and attached to the fabric to form a NFC antenna structure with specific steps as follows:

   S1. making LIG material into yarn;
   S2. embroidering the LIG yarn onto the fabric according to the designed NFC antenna pattern;
   S3. applying laser induction on the NFC antenna to convert the LIG yarn into graphene with conductivity;
   S4. connecting the NFC antenna to the near-field communication circuit.

2. The manufacturing method of Near-Field wireless communication antennas by using textile materials of claim 1, wherein the fabric comprises dielectric fabrics having woven, non-woven, or knitted structures, and served as the substrate for the NFC antenna.

3. The manufacturing method of Near-Field wireless communication antennas by using textile materials of claim 1, wherein the LIG material is selected from polyimide, polysulfone, polyether sulfone, polyphenylsulfone, or carbon-based materials containing cyclic carbon structures in crystals.

4. The manufacturing method of Near-Field wireless communication antennas by using textile materials of claim 1, wherein the wavelength of the laser ranged between 9.3 μm to 10.6 μm, the laser energy ranging from 50 W to 75 W, a duty cycle ranged between 4% to 10%, a laser frequency of 6 kHz, and a pulse count ranged between 30 to 1000 PPI.

5. The manufacturing method of Near-Field wireless communication antennas by textile materials of claim 1, wherein the diameter of the laser spot ranged between 60 μm to 90 μm.

6. The manufacturing method of Near-Field wireless communication antennas by using textile materials of claim 1, wherein the energy density of the laser ranged between 5 mJ/cm$^2$ to 200 mJ/cm$^2$.

7. The manufacturing method of Near-Field wireless communication antennas by using textile materials of claim 1, wherein a pulse length of the laser emission device ranged between 8 to 12 ps, a wavelength ranged between 9 to 11 $\mu$m, and a repetition rate ranged between 490 kHz to 19.9 MHz.

8. The manufacturing method of Near-Field wireless communication antennas by using textile materials of claim 1, wherein the NFC antenna is shaped as a rectangular loop, a circular loop, or a polygonal loop.

9. The manufacturing method of Near-Field wireless communication antennas by using textile materials of claim 1, wherein the NFC antenna is placed on the dielectric fabric substrate, the antenna coil embroidered by LIG yarn is directly connected to the chip.

10. The manufacturing method of Near-Field wireless communication antennas by using textile materials of claim 1, wherein the dielectric fabric adopts antenna coils and chips embroidered with conductive LIG yarn to directly achieve antenna impedance matching, that is equivalent inductance; when conjugate matched, the NFC antenna and chip is arranged to operate at 13.56 MHz without any tuning circuit.

11. The manufacturing method of Near-Field wireless communication antennas by textile materials of claim 1, wherein the NFC antenna has good breathability and moisture permeability.

12. The manufacturing method of Near-Field wireless communication antennas by using textile materials of claim 1, wherein the NFC antenna has excellent resistance to tensile deformation, bending deformation, and twisting deformation.

13. The manufacturing method of Near-Field wireless communication antennas by using textile materials of claim 1, wherein the NFC antenna is arranged to be applied to electronic platforms, including smartphones, reading devices, smartwatches, smart bands, computers, and POS terminals.

14. The manufacturing method of Near-Field wireless communication antennas by using textile materials of claim 1, wherein the fabric is made of natural or synthetic fibers.

Fig. 1a

Fig. 1b

Fig. 1c

Fig. 2a

Fig. 2b

Fig. 3a

Fig.3b

Fig. 3c

Fig. 4a

Fig. 4b

Fig. 5a

Fig. 5b

Fig. 6

| LIG yarn | Embroider the LIG yarn onto the fabric according to the pattern of the NFC antenna. | Use laser induction to convert the LIG yarn into a conductive NFC antenna. | Connect the NFC antenna to the near-field communication circuit. |

Fig. 7

Europäisches Patentamt
European Patent Office
Office européen des brevets

## EUROPEAN SEARCH REPORT

**Application Number**

EP 25 15 1663

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | IT 2019 0001 3092 A1 (TORINO POLITECNICO [IT]) 26 January 2021 (2021-01-26) | 1,3-7, 11-14 | INV. H05K1/03 |
| Y | * page 9, line 24 - page 10, line 17 * * page 12, line 10 - page 13, line 2 * * page 13, line 24 - page 14, line 29 * * page 15, line 24 - page 16, line 24 * * figures 1, 2 * | 2,8-10 | H05K1/16 H05K3/10 |
| | ----- | | |
| Y | US 2024/196527 A1 (KIM YOUNG-JIN [KR] ET AL) 13 June 2024 (2024-06-13) * paragraphs [0041] - [0045], [0047], [0051], [0052], [0059], [0060], [0075], [0083], [0088] - [0093]; figures 1-3, 5, 8, 10 * | 1-14 | |
| | ----- | | |
| Y | WO 2023/042159 A1 (SML BRAND IDENTIFICATION SOLUTIONS LTD [CN]) 23 March 2023 (2023-03-23) * page 5, line 21 - page 7, line 12; figures 1-3 * | 1-14 | |
| | ----- | | TECHNICAL FIELDS SEARCHED (IPC) |
| A | JIA ZHU ET AL: "Direct Laser Processing and Functionalizing PI/PDMS Composites for an On-Demand, Programmable, Recyclable Device Platform", ADVANCED MATERIALS, VCH PUBLISHERS, DE, vol. 36, no. 35, 18 April 2024 (2024-04-18), page n/a, XP072693950, ISSN: 0935-9648, DOI: 10.1002/ADMA.202400236 * page 8, right-hand column - page 9, left-hand column; figures 1, 5 * | 1-14 | H05K D03D H01Q |
| | ----- | | |
| | -/-- | | |

The present search report has been drawn up for all claims

| Place of search | Date of completion of the search | Examiner |
|---|---|---|
| Munich | 3 June 2025 | Batev, Petio |

EPO FORM 1503 03.82 (P04C01)

**page 1 of 2**

Europäisches Patentamt

European Patent Office

Office européen des brevets

## EUROPEAN SEARCH REPORT

**Application Number**

EP 25 15 1663

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MATTEO PARMEGGIANI ET AL: "Laser-induced graphenization of textile yarn for wearable electronics application", SMART MATERIALS AND STRUCTURES, IOP PUBLISHING LTD., BRISTOL, GB, vol. 30, no. 10, 24 August 2021 (2021-08-24), page 105007, XP020369324, ISSN: 0964-1726, DOI: 10.1088/1361-665X/AC182C [retrieved on 2021-08-24] * the whole document * ----- | 1-14 | |
| | | | **TECHNICAL FIELDS SEARCHED (IPC)** |

The present search report has been drawn up for all claims

| Place of search | Date of completion of the search | Examiner |
|---|---|---|
| Munich | 3 June 2025 | Batev, Petio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 25 15 1663

This annex lists the patent family members relating to the patent documents cited in the above-mentioned European search report.
The members are as contained in the European Patent Office EDP file on
The European Patent Office is in no way liable for these particulars which are merely given for the purpose of information.

03-06-2025

| Patent document cited in search report | Publication date | Patent family member(s) | | Publication date |
|---|---|---|---|---|
| IT 201900013092 A1 | 26-01-2021 | ------------------------------------ | | |
| US 2024196527 A1 | 13-06-2024 | NONE | | |
| WO 2023042159 A1 | 23-03-2023 | CN | 118020075 A | 10-05-2024 |
| | | EP | 4402606 A1 | 24-07-2024 |
| | | US | 2024403574 A1 | 05-12-2024 |
| | | WO | 2023042159 A1 | 23-03-2023 |